(19) Europäisches Patentamt / European Patent Office / Office européen des brevets

(11) **EP 3 693 997 B1**

(12) **FASCICULE DE BREVET EUROPEEN**

(45) Date de publication et mention de la délivrance du brevet:
**06.09.2023 Bulletin 2023/36**

(21) Numéro de dépôt: **20155524.0**

(22) Date de dépôt: **05.02.2020**

(51) Classification Internationale des Brevets (IPC):
**H01L 27/146** (2006.01)

(52) Classification Coopérative des Brevets (CPC):
**H01L 27/1463; H01L 27/14649; H01L 27/14694**

(54) **MATRICE DE PHOTO-DÉTECTEURS À BARRIÈRE AVEC PIXELLISATION PAR DÉPLÉTIONS LOCALES**

FOTODETEKTORENMATRIX MIT BARRIERE UND MIT PIXELIERUNG DURCH LOKALE VERARMUNGEN

PHOTO-DETECTOR ARRAY WITH BARRIER WITH PIXELLATION BY LOCAL DEPLETION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.02.2019 FR 1901220**

(43) Date de publication de la demande:
**12.08.2020 Bulletin 2020/33**

(73) Titulaire: **Commissariat à l'énergie atomique et aux énergies alternatives**
**75015 Paris (FR)**

(72) Inventeurs:
• **BOULARD, François**
**38054 GRENOBLE CEDEX 09 (FR)**
• **CERVERA, Cyril**
**38054 GRENOBLE CEDEX 09 (FR)**
• **FERRON, Alexandre**
**38054 GRENOBLE CEDEX 09 (FR)**

(74) Mandataire: **Brevalex**
**56, Boulevard de l'Embouchure**
**B.P. 27519**
**31075 Toulouse Cedex 2 (FR)**

(56) Documents cités:
**EP-A1- 3 089 223    EP-A1- 3 407 392**
**US-A1- 2008 111 152    US-A1- 2010 258 894**

**Description**

**DOMAINE TECHNIQUE**

L'invention se rapporte au domaine des photo-détecteurs à barrière, et plus particulièrement à un dispositif matriciel comportant une pluralité de photo-détecteurs à barrière.

**ETAT DE LA TECHNIQUE ANTERIEURE**

Les photo-détecteurs à barrière désignent des dispositifs de photo-détection qui comportent, superposées les unes au-dessus des autres, une couche d'absorption en matériau semi-conducteur dopé, dans laquelle des photons incidents sont absorbés et génèrent des porteurs de charge, une couche barrière, et une couche de contact en matériau semi-conducteur dopé, pour polariser le photo-détecteur. La couche d'absorption et la couche de contact présentent chacune une faible valeur de largeur de bande interdite, ou gap. La couche barrière est agencée entre la couche d'absorption et la couche de contact, et présente un gap élevé. La différence de gap entre la couche barrière et la couche d'absorption se reporte majoritairement sur l'une ou l'autre parmi la bande de conduction ou la bande de valence, et de telle sorte que la couche barrière forme une barrière unipolaire pour les porteurs de charge de la couche d'absorption. Le terme « barrière unipolaire » désigne une barrière de potentiel qui bloque un type de porteur de charge (trou ou électron) et laisse passer l'autre type de porteur de charge (électron ou trou). La couche barrière forme plus particulièrement une barrière de potentiel qui empêche la circulation des porteurs majoritaires, entre la couche d'absorption et la couche de contact, et qui autorise la circulation des porteurs minoritaires, depuis la couche d'absorption vers la couche de contact. La couche barrière autorise ainsi la transduction d'un signal lumineux en un signal électrique, en laissant passer dans la couche de contact les porteurs minoritaires photo-générés dans la couche d'absorption, tout en limitant le courant d'obscurité de porteurs majoritaires, en particulier en empêchant leur transport jusqu'à la couche de contact.

On peut réaliser des matrices de photo-détecteurs, réunissant une pluralité de photo-détecteurs à barrière. Les différents pixels d'une telle matrice peuvent partager une même couche d'absorption et une même couche barrière, et comporter chacun une zone de contact dédiée. Les zones de contact des différents pixels sont formées dans une même couche de contact, et isolées chacune des zones de contact voisines par des tranchées. Un inconvénient de cette solution est que la gravure des tranchées génère des défauts de matériau dans la couche de contact, sur les flancs et le fond des tranchées gravées. Ces défauts de matériau génèrent des courants qui dégradent la sensibilité des photo-détecteurs. En outre, la matrice de photo-détecteurs ainsi réalisée présente une topologie de surface, sur laquelle le dépôt d'une couche de passivation est plus difficile à mettre en oeuvre que sur une surface plane. Enfin, la gravure libère des régions de la couche barrière qui peuvent s'oxyder. Cette oxydation détériore les performances des photo-détecteurs, et limite les rendements de fabrication.

Afin de remédier à ces inconvénients, le document US 8,502,271 propose une matrice de photo-détecteurs dans laquelle les tranchées gravées sont remplacées par des régions de séparation qui s'étendent directement dans la couche de contact. Les régions de séparation présentent un dopage de type opposé à celui du restant de la couche de contact, et permettent ainsi de bloquer le flux de porteurs majoritaires dans la couche de contact. Cette solution permet de s'affranchir des inconvénients liés à la gravure. L'incorporation et l'activation d'éléments dopants dans la couche de contact génèrent cependant des défauts de structure qui sont sources de courant d'obscurité.

EP 3 089 223 A1 décrit une matrice de photo-détecteurs selon l'art antérieur.

Un objectif de la présente invention est de proposer un dispositif matriciel de photo-détection comportant une pluralité de photo-détecteurs à barrière, et qui ne présente pas les inconvénients de l'art antérieur. En particulier, un but de la présente invention est de proposer un dispositif matriciel de photo-détection comportant une pluralité de photo-détecteurs à barrière, avec un courant d'obscurité inférieur à celui des dispositifs de l'art antérieur.

**EXPOSÉ DE L'INVENTION**

Cet objectif est atteint avec un dispositif de photo-détection comportant une matrice de pixels, où chaque pixel comprend un photo-détecteur à barrière, et où ladite matrice de pixels comporte :

- une couche d'absorption, une couche barrière, et une couche de contact, agencées superposées avec la couche barrière située entre la couche d'absorption et la couche de contact, où la couche barrière est apte à former une barrière de potentiel bloquant la circulation de porteurs majoritaires entre la couche d'absorption et la couche de contact et autorisant la circulation de porteurs minoritaires depuis la couche d'absorption vers la couche de contact ; et
- au moins un élément de séparation, pour délimiter les pixels de ladite matrice de pixels.

Le terme « photo-détecteur à barrière » est défini en introduction.

La couche barrière est apte à former une barrière de potentiel bloquant la circulation de porteurs majoritaires (de la couche d'absorption, respectivement la couche de contact) entre la couche d'absorption et la couche de contact. En d'autres termes, ladite barrière de potentiel bloque la circulation de porteurs majoritaires dans un sens et/ou dans l'autre, entre la couche d'absorption et la couche de contact. Elle peut en particulier bloquer la circulation de porteurs majoritaires de la couche d'absorption, depuis la couche d'absorption vers la couche de contact. En outre, ladite barrière de potentiel autorise la circulation de porteurs minoritaires de la couche d'absorption, depuis la couche d'absorption vers la couche de contact.

La circulation, ou transport, ou collection des porteurs de charges, se fait par exemple par diffusion de porteurs, ou par dérive (drift, en anglais) sous l'effet d'un champ électrique.

La couche de contact est une couche en matériau semiconducteur petit gap, électriquement conductrice. En particulier, elle présente une largeur de bande interdite strictement inférieure à celle de la couche barrière. La couche de contact est apte à réaliser un contact de type ohmique avec au moins un plot de contact électrique. L'au moins un plot de contact électrique est de préférence en métal.

On comprend qu'en fonctionnement, la collecte des porteurs de charge s'effectue dans la couche de contact.

Selon l'invention, l'au moins un élément de séparation s'étend au-dessus de la couche de contact, du côté opposé à la couche barrière. L'au moins un élément de séparation est apte à former au moins une zone de déplétion qui s'étend dans la couche de contact et forme une barrière de potentiel bloquant la circulation de porteurs de charges d'un pixel à l'autre de la matrice de pixels.

En d'autres termes, l'idée à la base de l'invention consiste à délimiter des pixels à l'aide d'une barrière de potentiel, formée dans la couche de contact sous l'effet d'un élément de séparation externe à ladite couche de contact.

Une zone de déplétion, ou zone désertée, est une zone dépourvue de porteurs de charges libres, ou porteurs majoritaires, dans un matériau semiconducteur dopé. Une zone de déplétion se forme par exemple dans une diode à jonction p-n (ou n-p), du fait de la diffusion des porteurs de charges autour de la jonction. Une zone de déplétion peut aussi se former sous l'effet d'un champ électrique, dans la couche en matériau semiconducteur d'une capacité Métal-Oxyde-Semiconducteur (capacité MOS). D'autres dispositifs électroniques à base de matériau semiconducteur peuvent également présenter une zone de déplétion.

Au niveau d'une zone de déplétion, le potentiel électrique passe progressivement d'une valeur basse à une valeur haute. On comprend donc que la présence d'une zone de déplétion dans la couche de contact se traduit par la présence, dans la couche de contact, d'un puits de potentiel renversé centré sur ladite zone de déplétion. L'au moins une zone de déplétion selon l'invention forme donc une barrière de potentiel, qui s'étend dans la couche de contact au niveau de ladite zone de déplétion. Cette barrière de potentiel bloque le transport latéral de porteurs de charges de la couche de contact. La barrière de potentiel délimite ainsi une pluralité de zones dans la couche de contact, définissant ainsi les pixels de la matrice de pixels.

Selon l'invention, l'au moins une zone de déplétion et la barrière de potentiel associée s'étendent donc dans la couche de contact, entre les pixels de la matrice de photo-détecteurs, et de préférence selon des lignes qui s'entrecroisent.

L'au moins une zone de déplétion selon l'invention est formée à l'aide de l'au moins un élément de séparation. Cet élément de séparation forme, avec la couche de contact, une structure apte à générer une zone de déplétion dans la couche de contact. Ladite structure est par exemple une capacité MOS ou empilement semiconducteur à jonction p-n (ou n-p). L'élément de séparation s'étend au-dessus de la couche de contact, du côté de la couche de contact opposé à la couche barrière, et de préférence directement sur la couche de contact. Il ne dépasse pas jusqu'à l'intérieur de la couche de contact, de sorte qu'il ne modifie pas la composition chimique ni la structure cristalline de la couche de contact. Il ne nécessite pas non plus de graver la couche de contact.

L'invention offre ainsi une solution pour délimiter des photo-détecteurs individuels de type photo-détecteur à barrière, dans un empilement comportant une couche d'absorption, une couche barrière, et une couche de contact, et qui ne présente pas les inconvénients liés à cette pixellisation dans l'art antérieur. En particulier, l'invention permet de s'affranchir des inconvénients liés à la gravure de la couche de contact, ou à l'implantation d'impuretés dans cette dernière. Une zone interpixel de la couche de contact ne présente pas une densité de défauts structurels plus élevée ni une composition chimique différente de celle du restant de la couche contact. On s'affranchit ainsi de défauts de structure à l'origine d'un courant d'obscurité dans l'art antérieur. En outre, l'invention permet de s'affranchir de tout risque d'oxydation de la couche barrière lié à une gravure de la couche de contact. L'invention facilite également le dépôt d'une couche de passivation pour protéger la couche de contact, grâce à une configuration planaire. Enfin, on évite une étape sensible d'implantation ou diffusion locale de dopants dans la couche de contact, ce qui améliore un rendement de fabrication en comparaison avec l'art antérieur.

En fonctionnement, la couche d'absorption est avantageusement non déplétée.

De préférence, le dispositif selon l'invention est configuré pour qu'en fonctionnement, l'au moins une zone de déplétion s'étende sur toute l'épaisseur de la couche de contact.

Selon un premier mode de réalisation avantageux, l'au moins un élément de séparation comprend une pluralité de bandes métalliques, agencées le long de lignes de séparation entre les pixels, et au moins une couche en matériau électriquement isolant située entre la couche de contact et lesdites bandes métalliques, de manière à former au moins une capacité Métal-Oxyde-Semiconducteur qui s'étend le long desdites lignes de séparation entre les pixels. Les bandes métalliques peuvent être électriquement connectées à une source de tension configurée pour fournir une tension de polarisation non nulle. La source de tension est avantageusement configurée pour fournir une tension de polarisation supérieure ou égale à 500 mV en valeur absolue. Chaque pixel de la matrice de pixels peut comporter en outre un plot de contact électrique, situé directement sur la couche de contact du côté opposé à la couche barrière, avec les bandes métalliques constituées d'un même matériau que lesdits plots de contact électrique. De préférence, chaque pixel de la matrice de pixels comporte en outre un plot de contact électrique, situé directement sur la couche de contact du côté opposé à la couche barrière, et l'au moins une couche en matériau électriquement isolant recouvre l'intégralité de la couche de contact excepté aux emplacements desdits plots de contact électrique.

Selon un deuxième mode de réalisation avantageux, l'au moins un élément de séparation comporte des bandes dopées en matériau semi-conducteur, situées chacune directement sur la couche de contact du côté opposé à la couche barrière, et présentant chacune un dopage n ou p de manière à former une jonction p-n ou n-p avec la couche de contact. De préférence, les bandes dopées ne sont pas connectées à une source de tension pour polariser ces dernières. L'épaisseur des bandes dopées est avantageusement inférieure ou égale à 15 nm, où l'épaisseur est mesurée selon un axe orthogonal au plan de la matrice de pixels.

Selon l'invention, l'au moins un élément de séparation peut avoir la forme d'une grille continue.

En variante, l'au moins un élément de séparation peut avoir la forme d'une grille discontinue, constituée d'une pluralité d'éléments de séparation disjoints. Dans ce cas, une distance, entre deux éléments de séparation répartis le long d'une même ligne droite reliant deux bords opposés de la matrice de pixels, est avantageusement inférieure ou égale à deux fois une étendue de la zone de déplétion dans la couche de contact et dans le sens de la profondeur. De préférence, les pixels de la matrice de pixels sont agencés selon un maillage carré ou rectangulaire, et chaque pixel est encadré par quatre éléments de séparation disjoints.

De manière avantageuse, les photo-détecteurs à barrière sont de type nBn, avec la couche d'absorption dopée n et la couche de contact dopée n.

L'invention couvre également un système de photo-détection comportant un dispositif de photo-détection selon l'invention et une pluralité de plots de contact électrique, dans lequel les plots de contact électrique s'étendent directement sur la couche de contact, en contact physique direct avec cette dernière du côté opposé à la couche barrière, et établissent chacun avec la couche de contact un contact électrique de type ohmique. Les plots de contact électrique sont de préférence en métal.

## BRÈVE DESCRIPTION DES DESSINS

La présente invention sera mieux comprise à la lecture de la description d'exemples de réalisation donnés à titre purement indicatif et nullement limitatif, en faisant référence aux dessins annexés sur lesquels :

- la figure 1 illustre de façon schématique, et selon une vue en coupe, un premier mode de réalisation d'un dispositif de photo-détection selon l'invention ;
- les figures 2A à 2D illustrent des profils d'énergie dans le dispositif de la figure 1 ;
- la figure 3 illustre de façon schématique, et selon une vue de dessus, le dispositif de la figure 1 ;
- la figure 4 illustre une épaisseur de la zone de déplétion dans la couche de contact, en fonction d'une densité de dopage de ladite couche de contact, dans le mode de réalisation de la figure 1 ;
- la figure 5 illustre de façon schématique, et selon une vue en coupe, un deuxième mode de réalisation d'un dispositif de photo-détection selon l'invention ;
- les figures 6A à 6D illustrent des profils d'énergie dans le dispositif de la figure 5 ;
- la figure 7 illustre une épaisseur de la zone de déplétion dans la couche de contact, en fonction d'une densité de dopage de ladite couche de contact, dans le mode de réalisation de la figure 5 ; et
- les figures 8A et 8B illustrent de façon schématique, chacun selon une vue de dessus, deux variantes du dispositif de la figure 5.

## EXPOSÉ DÉTAILLÉ DE MODES DE RÉALISATION PARTICULIERS

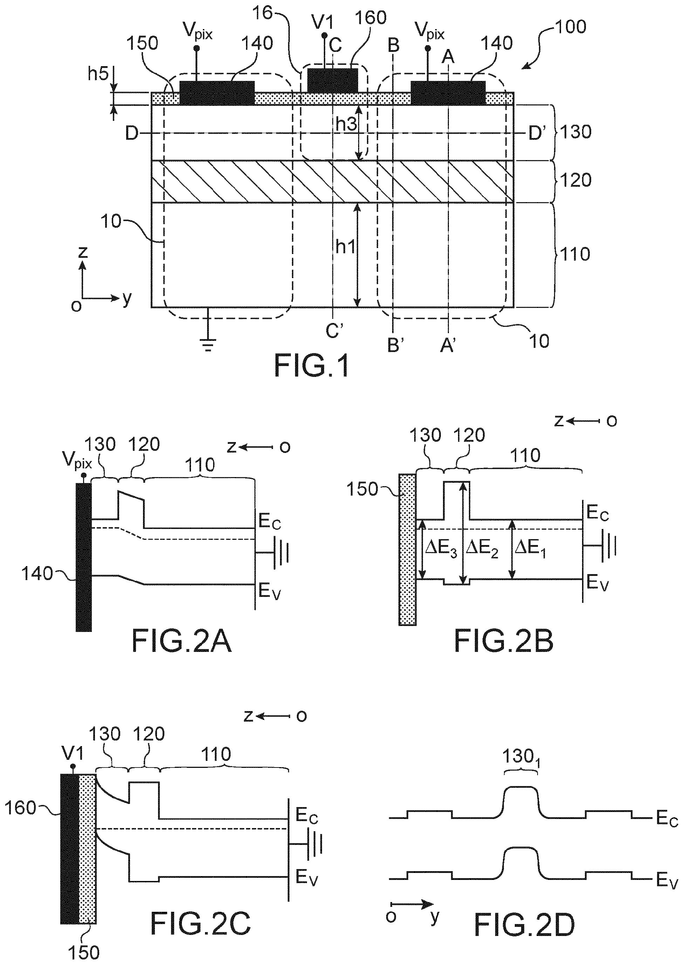

La figure 1 illustre, selon un vue en coupe dans le plan (y0z) d'un repère orthonormé (0xyz), un dispositif de photo-détection 100 selon un premier mode de réalisation de l'invention.

Le dispositif de photo-détection 100 comporte, superposées l'une au-dessus de l'autre le long de l'axe (0z) :

- une couche d'absorption 110 ;
- une couche barrière 120 ; et
- une couche de contact 130.

Cet empilement de couches forme une hétérostructure, qui est réalisé par exemple par épitaxie par jet moléculaire sur un substrat GaSb.

Chacune de ces couches s'étend dans un plan parallèle au plan (x0y), parallèle au plan de la matrice de pixels telle que définie dans la suite. La couche barrière 120 s'étend entre la couche d'absorption 110 et la couche de contact 130, en contact physique direct avec ces dernières le long de plans parallèles au plan (x0y).

La couche d'absorption 110 est constituée d'un matériau semi-conducteur dopé, ici dopé n (excès d'électrons). Le matériau semi-conducteur est par exemple un alliage d'indium, arsenic et antimoine. La couche d'absorption 110 est destinée à absorber des photons dont la longueur d'onde est située dans une plage de sensibilité spectrale du dispositif de photo-détection 100. En fonctionnement, les photons absorbés dans la couche d'absorption 110 y génèrent des porteurs de charge, en particulier des porteurs minoritaires qui circulent jusqu'à la couche barrière 120. Ici, les porteurs minoritaires sont des trous, chargés positivement. La couche d'absorption 110 présente une épaisseur h1 de quelques micromètres, proche d'une profondeur d'absorption de la lumière dans le matériau de la couche d'absorption aux longueurs d'onde détectée par le dispositif de photo-détection 100. L'épaisseur h1 est mesurée selon un axe (0z) orthogonal au plan (x0y) de la couche d'absorption 110. La couche d'absorption 110 présente une première valeur du gap, $\Delta E_1$.

La couche barrière 120 est constituée d'un matériau semi-conducteur, de préférence dopé avec le même type de dopage que la couche d'absorption 110. Le matériau semi-conducteur est par exemple un alliage d'aluminium, arsenic et antimoine. La couche barrière 120 présente une deuxième valeur du gap, $\Delta E_2$, avec $\Delta E_2$ supérieur à $\Delta E_1$. La différence de gap entre la couche barrière 120 et la couche d'absorption 110 se reporte ici majoritairement sur la bande de conduction, de sorte que la couche barrière 120 forme une barrière unipolaire qui bloque la circulation des porteurs majoritaires (électrons) de la couche d'absorption 110, et autorise la circulation des porteurs minoritaires (trous) de la couche d'absorption.

La couche de contact 130 est constituée d'un matériau semi-conducteur dopé, ici dopé n. Le matériau semi-conducteur peut être constitué des mêmes éléments chimiques que le matériau de la couche d'absorption 110, le cas échéant dans les mêmes proportions. Ici la couche de contact 130 est constituée d'un alliage d'indium, arsenic et antimoine. La couche de contact 130 présente une épaisseur h3 inférieure au micromètre, de préférence inférieure à 500 nm. L'épaisseur h3 est mesurée selon l'axe (0z). La couche de contact 130 est destinée à polariser le dispositif de photo-détection 100. Pour cela, une pluralité de plots de contact électrique 140 s'étendent en contact physique direct avec la couche de contact 130, sur son côté opposé à la couche barrière 120. En fonctionnement, ces plots de contact électrique 140, en métal, sont connectés à une source de tension apte à fournir une tension de polarisation Vpix, ici une tension négative.

En fonctionnement, l'absorption de photons dans la couche d'absorption 110 génère dans cette couche des porteurs minoritaires, chargés ici positivement, qui circulent jusqu'à la couche de contact 130 en traversant la couche barrière 120, et génèrent un signal électrique qui peut être mesuré via les plots de contact électrique 140. Des porteurs majoritaires, chargés ici négativement, sont quant à eux empêchés de circuler depuis la couche d'absorption 110 jusqu'à la couche de contact 130, grâce à la couche barrière 120. Le dispositif de photo-détection 100 décrit ici est un dispositif de type « nBn », traduisant l'empilement d'une couche d'absorption dopée n, une couche barrière, et une couche de contact dopée n.

La couche de contact 130 est recouverte d'une couche 150 en matériau électriquement isolant. La couche 150 s'étend directement sur la couche de contact 130, du côté opposé à la couche barrière 120, sauf aux emplacements des plots de contact électrique 140. La couche 150 est par exemple en dioxyde de silicium, ou tout autre oxyde par exemple de type $SiO_x$, $HfO_x$ ou nitrure de type $SiN_x$. La couche 150 présente de préférence, en plus de sa fonction d'isolant électrique, une fonction de protection de la couche de contact 130. En d'autres termes, elle forme également une couche de passivation sur la couche de contact 130. La couche 150 présente une épaisseur h5 comprise de préférence entre 10 nm et 300 nm. L'épaisseur h5 est mesurée selon un axe (0z) orthogonal au plan (x0y) de la couche 150.

La couche 150 peut être déposée par n'importe quelle technique classique de dépôt ou de croissance de monocouche ou multicouche telle que l'oxydation et la nitruration thermique, le dépôt par pulvérisation cathodique ou faisceau d'ions, le dépôt par couche atomique, l'électrochimie, etc.

Le dispositif de photo-détection 100 comporte également des bandes métalliques 160, qui s'étendent dans un plan (x0y) parallèle aux plans des couches 110, 120 et 130. Les bandes métalliques 160 s'étendent en contact physique direct avec la couche 150, du côté opposé à la couche de contact 130. Elles sont isolées électriquement des plots de contact électrique 140, espacées ici de ces derniers par un espace. Les bandes métalliques 160 sont formées par une ou plusieurs couches d'un métal, chaque couche pouvant être en or, titane, nickel, platine, ou un alliage d'au moins deux de ces métaux. Les bandes métalliques 160 sont connectées électriquement à une source de tension, non représentée, apte à fournir une tension de polarisation V1, ici une tension négative. V1 est strictement supérieure à Vpix, en valeur absolue. La valeur absolue de V1 est comprise de préférence entre 0,5 V et 5 V.

Les bandes métalliques 160 sont avantageusement réalisées par ouverture localisée de la couche 150, par photolithographie et gravure. Les procédés classiques de gravure humide ou sèche peuvent être utilisés. Par exemple, dans le cas d'une couche 150 en SiOz, une gravure par plasma fluoré permet d'ouvrir la couche 150 sélectivement à la couche contact 130. Ensuite, on dépose une ou plusieurs couches de métaux, que l'on grave par photolithographie et gravure par abrasion ionique. Ces étapes sont avantageusement suivies par des étapes connues de prise de contact, hybridation sur circuit de lecture, et retrait d'un substrat de support, ici le substrat GaSb.

L'empilement constitué par les bandes métalliques 160, et les portions des couches 150 et 130 situées au regard desdites bandes, forme une capacité MOS, référencée 16 sur la figure 1.

On décrit dans la suite des profils d'énergie de la bande de valence et de la bande de conduction, selon différentes coupes dans le dispositif 100. Ces profils correspondent au dispositif 100 en fonctionnement, avec les bandes métalliques 160 polarisées par la tension V1, les plots de contact électrique 140 polarisés par la tension Vpix, et la couche d'absorption 110 reliée à la masse.

La figure 2A illustre les profils d'énergie de la bande de valence (Ev) et de la bande de conduction (Ec), le long d'un axe AA' parallèle à l'axe (0z) et passant par un plot de contact électrique 140.

La figure 2B illustre les profils d'énergie de la bande de valence (Ev) et de la bande de conduction (Ec), le long d'un axe BB' parallèle à l'axe (0z) et passant en dehors d'un plot de contact électrique 140 et en dehors d'une bande métallique 160.

Les profils de la figure 2B se rapportent à la situation hors polarisation de la couche de contact 130. Comme détaillé ci-avant, le gap dans la couche d'absorption 110 prend la valeur $\Delta E_1$, tandis que le gap dans la couche barrière 120 prend la valeur $\Delta E_2$ bien supérieure à $\Delta E_1$. Dans la couche de contact 130, le gap prend une troisième valeur $\Delta E_3$ sensiblement égale à $\Delta E_1$, bien inférieure à $\Delta E_2$. Les profils d'énergie des bandes de valence et de conduction sont adaptés pour que la couche barrière puisse, lorsque la couche de contact 130 est polarisée, bloquer sélectivement le flux de porteurs majoritaires de la couche d'absorption et laisser passer le flux de porteurs minoritaires. Dans le cas d'un dispositif de type « nBn » tel que décrit ici, cela se traduit par une faible différence d'énergie au niveau des bandes de valences, entre la couche barrière d'une part et les couches d'absorption et de contact d'autre part, et une forte différence d'énergie au niveau des bandes de conduction, entre ces mêmes couches. En d'autres termes, la différence de gap entre lesdites couches se reporte majoritairement sur la bande de conduction. Ici, l'énergie de la bande de conduction présente une forme en créneau, avec une valeur haute dans la couche barrière et des valeurs basses dans les couches d'absorption et de contact. L'énergie de la bande de valence présente quant à elle une forme en créneau, avec une valeur basse dans la couche barrière et des valeurs légèrement supérieures dans les couches d'absorption et de contact.

Les profils d'énergie illustrés en figure 2B permettent, lorsque la couche de contact 130 est légèrement polarisée, d'obtenir l'effet recherché de blocage sélectif des porteurs de charge au niveau de la couche barrière 120, comme illustré en figure 2A.

La figure 2C illustre les profils d'énergie de la bande de valence (Ev) et de la bande de conduction (Ec), le long d'un axe CC' parallèle à l'axe (0z) et passant par une bande métallique 160. Les profils de la figure 2C correspondent à ceux de la figure 2B, sauf au niveau de la couche de contact 130. Dans la couche de contact 130, la capacité MOS formée par la couche de contact 130, la couche 150, et la bande métallique 160, forme une zone de déplétion. Cela se traduit par une forte augmentation de l'énergie moyenne des bandes de valence et de conduction, dans la couche de contact 130. Dans la couche de contact 130, l'énergie de la bande de conduction présente un gradient qui décroît le long de l'axe (0z), au fur et à mesure que l'on s'éloigne de la bande métallique 160. L'énergie sur la bande de valence présente le même profil que sur la bande de conduction. Ces profils d'énergie correspondent à la présence locale d'une barrière de potentiel, qui s'étend dans la couche de contact 130 au regard de la bande métallique 160.

Au niveau de l'interface entre la couche de contact 130 et la couche barrière 120, l'énergie sur la bande de conduction côté couche de contact 130 est inférieure à l'énergie sur la bande de conduction côté couche barrière 120. Ainsi l'apparition de la barrière de potentiel dans la couche de contact 130 ne perturbe pas le fonctionnement de la couche barrière en tant que barrière unipolaire.

La figure 2D illustre les profils d'énergie de la bande de valence (Ev) et de la bande de conduction (Ec), le long d'un axe DD' s'étendant à mi-hauteur dans la couche de contact 130, dans un plan parallèle au plan (x0y). La différence d'énergie entre la bande de valence et la bande de conduction est constante le long de l'axe DD'. Les profils d'énergie présentent chacun des bosses, situées dans des régions $130_1$ de la couche de contact s'étendant chacune au regard d'une bande métallique. Les bosses dépassent largement relativement aux autres zones sur les profils d'énergie, ce qui correspond bien à la présence d'une barrière de potentiel qui s'étend dans la couche de contact 130, au regard des bandes métalliques 160.

Grâce à ces barrières de potentiel, les porteurs de charges, en particulier les porteurs majoritaires, sont empêchés de circuler dans la couche de contact 130, au travers des régions $130_1$ situées au regard des bandes métalliques 160.

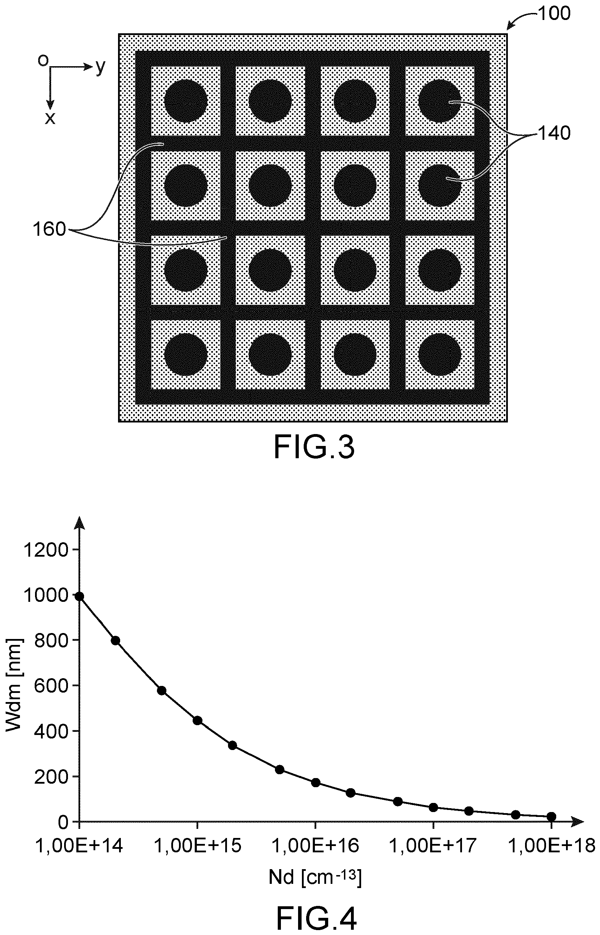

La figure 3 représente le dispositif 100, selon une vue de dessus. Comme illustré en figure 3, les bandes métalliques 160 s'étendent le long de lignes de séparation, sur la couche 150. Le projeté orthogonal de ces lignes de séparation, dans un plan (x0y) recevant la couche de contact 130, forme des lignes qui délimitent une série de zones dans la couche de contact 130, où chaque zone reçoit un et unique plot de contact électrique 140. Les bandes métalliques 160 délimitent ainsi une pluralité de pixels 10 dans le dispositif de photo-détection 100, où chaque pixel 10 comporte un et unique plot de contact électrique 140. Ici, les bandes métalliques 160 s'étendent plus particulièrement selon une grille, avec un plot de contact électrique 140 dans chaque trou de la grille. La grille est constituée de lignes qui s'étendent chacune en continu d'un bord à l'autre de la matrice de pixels.

L'empilement comportant la couche d'absorption 110, la couche barrière 120 et la couche de contact 130 forme ainsi, grâce aux bandes métalliques 160 et à la couche 150 en matériau électriquement isolant, une matrice de pixels dans laquelle chaque pixel 10 comporte un photo-détecteur à barrière. Les bandes métalliques 160 et la couche 150 en matériau électriquement isolant forment ensemble des éléments de séparation, pour délimiter les pixels 10 de ladite matrice. Les éléments de séparation s'étendent ici directement sur la couche de contact, du côté opposé à la couche barrière. Ils forment des zones de déplétion qui s'étendent localement dans la couche de contact 130. Les niveaux d'énergie dans ces zones de déplétion forment des barrières de potentiel, qui s'étendent localement dans la couche de contact et empêchent des porteurs de charge majoritaires dans la couche de contact de circuler, dans la couche de contact, d'un pixel à l'autre de la matrice de pixels. La matrice de pixels est une matrice planaire, puisque la couche de contact 130 ne présente pas de tranchées entre les pixels.

De préférence, la barrière de potentiel et la zone de déplétion associée s'étendent chacune selon toute l'épaisseur de la couche de contact. L'homme du métier saura dimensionner le dispositif selon l'invention de manière à obtenir cette caractéristique, notamment en ajustant l'épaisseur et la densité de dopage de la couche de contact 130.

En particulier, dans le cas où la tension de polarisation V1 est suffisamment élevée en valeur absolue pour atteindre le régime de forte inversion (soit une tension comprise généralement entre 500 mV et 5 V en valeur absolue), la distance maximale $W_{Dm}$ de déplétion des porteurs majoritaires dans la couche de contact 130 est donnée par l'équation :

$$W_{Dm} \approx \sqrt{\frac{4\varepsilon_{sc}kTln(\frac{N_d}{n_i})}{q^2 N_d}}$$

où $N_d$ est la densité de dopage dans la couche de contact 130, q est la charge électrique élémentaire, T est la température, k est la constante Boltzmann, $\varepsilon_{sc}$ est la permittivité diélectrique du matériau de la couche de contact 130, et $n_i$ est la densité intrinsèque de porteurs dans la couche de contact 130.

On peut déduire de cette équation des valeurs d'épaisseur et de densité de dopage de la couche de contact 130, permettant que la zone de déplétion s'étende selon toute l'épaisseur de la couche de contact 130.

La figure 4 illustre l'évolution $W_{Dm}$ (axe des ordonnées, en nm) en fonction de la densité de dopage dans la couche de contact 130 (axe des abscisses, en .cm$^{-3}$, en échelle logarithmique). La couche de contact 130 est ici en InAs$_{0.8}$Sb$_{0.2}$ dopé n, à une température de 150 K, avec une permittivité diélectrique $\varepsilon_{sc}$ égale à 15, et une densité intrinsèque de porteurs $n_i$ égale à

10$^{13}$.cm$^{-3}$. On voit qu'une couche de contact de 100 nm d'épaisseur peut être déplétée en porteurs majoritaires sur toute son épaisseur si son dopage est inférieur à 3.10$^{16}$.cm$^{-3}$. On voit également qu'une couche de contact dont la densité de dopage est égale à 10$^{15}$.cm$^{-3}$ conduit à une distance maximale de déplétion de 440 nm.

De manière connue dans le domaine des capacités MOS, l'épaisseur et la permittivité de la couche 150 influencent la valeur minimale, en valeur absolue, de la tension de polarisation V1 à appliquer aux bandes métalliques. Cette tension seuil dépend aussi de la densité de dopage de la couche de contact.

Les bandes métalliques 160 et les plots de contact électrique 140 peuvent être constitués d'un même matériau.

Les bandes métalliques 160 et les plots de contact électrique 140 peuvent être formés lors d'une même étape technologique de fabrication d'un dispositif selon l'invention, ce qui permet d'augmenter la vitesse de fabrication, et de s'affranchir du désalignement inhérent à l'utilisation de deux étapes technologiques. En variante, une première métallisation est utilisée pour former les plots de contact électrique 140, et une seconde métallisation est utilisée pour former les bandes métalliques 160. La première métallisation peut alors être réalisée avant le dépôt de la couche 150 formant également couche de passivation. Cela permet de réaliser une étape de guérison de l'interface entre la couche de contact et les plots de contact électrique 140, notamment pour améliorer le contact ohmique. L'absence de passivation à cette étape de guérison permet d'utiliser des procédés que ne supporterait pas la passivation, par exemple des traitements thermiques à haute température.

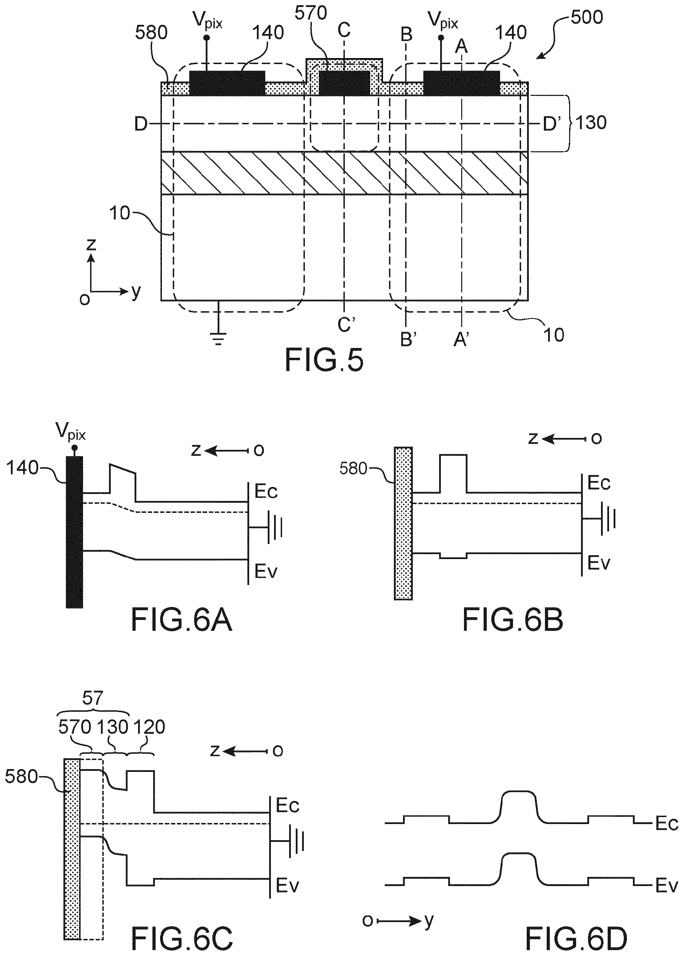

La figure 5 illustre selon un vue en coupe dans le plan (y0z) d'un repère orthonormé (0xyz), un dispositif de photo-détection 500 selon un deuxième mode de réalisation de l'invention. Le dispositif de photo-détection 500 ne sera décrit que pour ses différences relativement au dispositif 100 selon le premier mode de réalisation de l'invention. Ici, les éléments de séparation pour délimiter les pixels 10 sont formés plutôt par des bandes dopées 570, en matériau semi-conducteur. Les bandes dopées 570 présentent un type de dopage opposé à celui de la couche de contact 130, et s'étendent en contact physique direct avec la couche de contact 130 de manière à former avec elle une jonction planaire p-n (ou n-p). Ici, la couche de contact 130 est dopée n, et les bandes dopées 570 sont dopées p. Une couche de passivation 580 recouvre la couche de contact 130 et les bandes dopées 570, sauf aux emplacements des plots de contact électrique 140.

L'empilement constitué par les bandes dopées 570 et les portions de la couche de contact 130 situées au regard desdites bandes comporte une zone de déplétion, qui s'étend à la fois dans les bandes dopées 570 et dans la couche de contact 130.

Les figures 6A à 6D illustrent des profils d'énergie, selon différentes coupes dans le dispositif 500 de la figure 5. Ces profils correspondent au dispositif 500 en fonctionnement, avec les plots de contact électrique 140 polarisés par la tension Vpix et la couche d'absorption 110 reliée à la masse. De préférence, et comme c'est le cas ici, les bandes dopées 570 ne sont pas polarisées, et ne sont donc connectées à aucune source de tension. La déplétion est alors assurée uniquement par l'ajustement des épaisseurs et dopages de la couche de contact et des bandes dopées. Ainsi, il n'est pas nécessaire de recourir à un circuit spécifique gérant la polarisation des bandes dopées.

Les figures 6A et 6B illustrent des profils d'énergie de la bande de valence (Ev) et de la bande conduction (Ec), respectivement le long d'un axe AA' et d'un axe BB' tous deux parallèles à l'axe (0z) et passant respectivement par un plot de contact électrique 140 et entre un tel plot et une bande dopée 570. Les figures 6A et 6B sont respectivement identiques aux figures 2A et 2B.

La figure 6C illustre les profils d'énergie de la bande de valence (Ev) et de la bande de conduction (Ec), le long d'un axe CC' parallèle à l'axe (0z) et passant par une bande dopée 570. Les profils d'énergie de la figure 6C correspondent à ceux de la figure 6B, excepté au niveau de la couche de contact 130 et de la bande dopée 570. Dans l'ensemble 57 formé par la couche de contact 130 et de la bande dopée 570, la jonction p-n forme une zone de déplétion. Cela se traduit par une forte augmentation locale de l'énergie moyenne des bandes de valence et de conduction, dans cet ensemble 57. Dans cet ensemble 57, l'énergie de la bande de conduction présente un gradient centré sensiblement sur la jonction p-n entre la bande dopée 570 et la couche de contact 130, et décroissant le long de l'axe (0z), au fur et à mesure que l'on se rapproche de la couche barrière 120. L'énergie sur la bande de valence présente le même profil que sur la bande de conduction. Ces profils d'énergie correspondent à la présence locale d'une barrière de potentiel, qui s'étend notamment dans la couche de contact 130 au regard de la bande dopée 570.

Au niveau de l'interface entre la couche de contact 130 et la couche barrière 120, l'énergie sur la bande de conduction côté couche de contact 130 est inférieure à l'énergie sur la bande de conduction côté couche barrière 120. Ainsi l'apparition de la barrière de potentiel dans la couche de contact 130 ne perturbe pas le fonctionnement de la couche barrière en tant que barrière unipolaire.

La figure 6D illustre les profils d'énergie de la bande de valence (Ev) et de la bande de conduction (Ec), le long d'un axe DD' s'étendant à mi-hauteur dans la couche de contact 130, dans un plan parallèle au plan (x0y). On obtient les mêmes profils qu'à la figure 2D, montrant la présence d'une barrière de potentiel qui s'étend dans la couche de contact 130, ici au regard des bandes dopées 570.

Comme dans le premier mode de réalisation, ces barrières de potentiel empêchent les porteurs de charges de circuler dans la couche de contact 130 au-travers des régions situées ici au regard des bandes dopées 570.

Comme les bandes métalliques du premier mode de réalisation, les bandes dopées 570 s'étendent le long de lignes de séparation, de manière à délimiter une pluralité de pixels 10 dans le dispositif de photo-détection 500, où chaque pixel 10 comporte un et unique plot de contact électrique 140.

De préférence, la barrière de potentiel et la zone de déplétion associée s'étendent chacune selon toute l'épaisseur de la couche de contact. L'homme du métier saura dimensionner le dispositif selon l'invention, de manière à obtenir cette caractéristique, notamment en ajustant les épaisseurs et densités de dopage de la couche de contact 130 et des bandes dopées 570.

En particulier, l'extension $W_{ZCE}$ de la zone de déplétion est la somme de son extension $W_{nZCE}$ dans la couche de contact et de son extension $W_{pZCE}$ dans les bandes dopées, avec :

$$W_{nZCE} N_d = W_{pZCE} N_a$$

où Nd est la densité de dopage dans la couche de contact 130 et Na est la densité de dopage dans les bandes dopées 570. En outre, l'extension totale $W_{ZCE}$ est donnée par :

$$W_{ZCE} = \sqrt{\frac{2\varepsilon_{sc}}{q}\left(\frac{1}{Na} + \frac{1}{Nd}\right)(V_{BI} - V)}$$

où q est la charge électrique élémentaire, k est la constante Boltzmann, $\varepsilon_{sc}$ est la permittivité diélectrique du matériau de la couche de contact 130, V est une tension de polarisation des bandes dopées, et $V_{BI}$ est donné par l'équation :

$$V_{BI} = \frac{kT}{q} ln\left(\frac{Na.Nd}{n_i{}^2}\right)$$

avec T est la température et $n_i$ est la densité intrinsèque de porteurs dans la couche de contact 130.

On peut déduire de ces équations des valeurs d'épaisseur et de densité de dopage de la couche de contact 130, et de densité de dopage des bandes dopées 570, pour que la zone de déplétion s'étende selon toute l'épaisseur de la couche de contact.

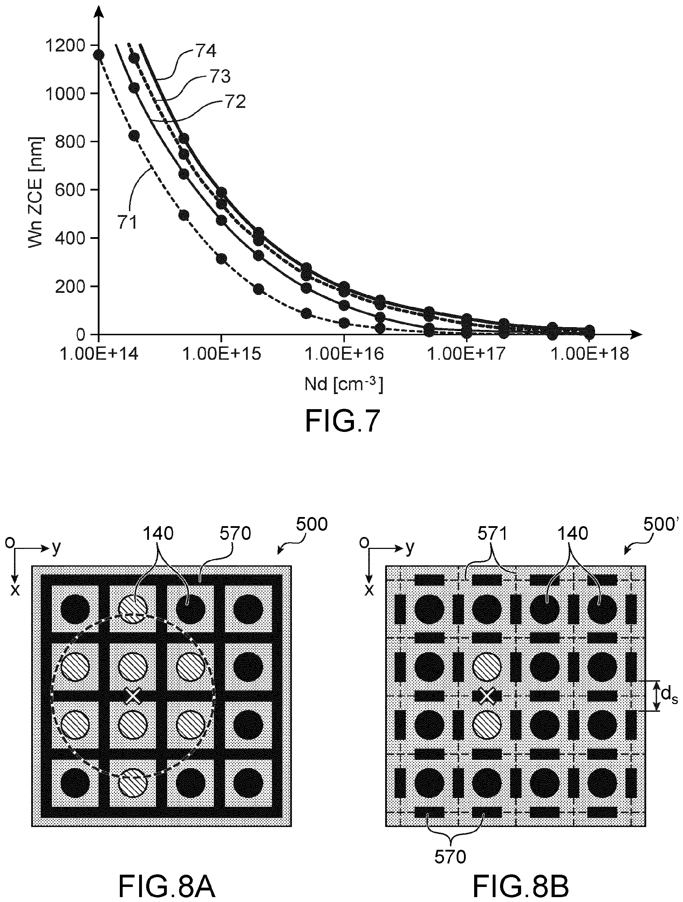

La figure 7 illustre l'évolution de $W_{nZCE}$ (axe des ordonnées, en nm) en fonction de la densité de dopage dans la couche de contact 130 (axe des abscisses, en .cm$^{-3}$, en échelle logarithmique), et pour différentes valeurs de la densité de dopage dans les bandes dopées 570. La couche de contact 130 est ici en InAso.sSbo.z dopé n, à une température de 150 K, avec une permittivité diélectrique $\varepsilon_{sc}$ égale à 15, et une densité intrinsèque de porteurs $n_i$ égale à $10^{13}$.cm$^{-3}$. Les courbes 71, 72, 73, 74 correspondent respectivement à une densité de dopage dans les bandes dopées de $10^{15}.cm^{-3}$, $10^{16}.cm^{-3}$, $10^{17}.cm^{-3}$, et $10^{18}.cm^{-3}$. On observe par exemple qu'une couche de contact avec une densité de dopage inférieure ou égale à $10^{15}.cm^{-3}$ est totalement déplétée sur une épaisseur de 310 nm, 475 nm, 540 nm, 590 nm, respectivement pour une densité de dopage des bandes dopées de $10^{15}.cm^{-3}$, $10^{16}.cm^{-3}$, $10^{17}.cm^{-3}$, et $10^{18}.cm^{-3}$. Pour assurer la déplétion totale de la couche de contact, son épaisseur doit donc être inférieure à ces valeurs. En outre, l'épaisseur de la bande dopée doit être supérieure à $W_{pZCE}$ pour permettre d'apporter tous les porteurs nécessaires à la formation de la zone de déplétion. On choisit par exemple une épaisseur de 200 nm et une densité de dopage Nd de $10^{15}.cm^{-3}$ pour la couche de contact, et une épaisseur de 20 nm et une densité de dopage Na de $10^{17}.cm^{-3}$ pour les bandes dopées. Dans ces conditions, $W_{nZCE}$ vaut 540 nm, soit une valeur bien supérieure à l'épaisseur de la couche de contact, ce qui permet que la zone de déplétion s'étende selon toute l'épaisseur de ladite couche de contact. En outre, $W_{pZCE}$ vaut 5 nm, soit une valeur bien inférieure à l'épaisseur des bandes dopées.

Dans ce deuxième mode de réalisation, les bandes dopées sont avantageusement réalisées par croissance puis gravure localisée d'une couche semi-conductrice dopée, ici dopée p. La gravure n'est pas critique. En effet, et comme montré ci-dessus, on peut dimensionner les épaisseurs de sorte que la couche de contact soit bien plus épaisse que les bandes dopées. On dispose ainsi d'une forte tolérance en profondeur pour la gravure, qui peut s'enfoncer légèrement dans la couche de contact sans nuire au bon fonctionnement du dispositif selon l'invention. La faible profondeur de la gravure facilite en outre une passivation des flancs de gravure. Par ailleurs, la gravure ne débouche pas sur une couche susceptible de s'oxyder.

La figure 8A illustre le dispositif 500 de la figure 5, selon une vue de dessus. On voit que les bandes dopées 570 s'étendent selon une grille continue, constituée de lignes droites qui s'étendent chacune en continu d'un bord à l'autre de la matrice de pixels, et avec un plot de contact électrique 140 dans chaque trou de la grille. La présence d'un défaut local dans la jonction p-n, sous les bandes dopées 570 (croix blanche sur la figure 8A), peut générer une fuite de charges. Cette fuite de charges empêche la formation d'une zone de déplétion, dans un rayon déterminé autour du défaut (cercle en pointillés). Une pluralité de pixels autour du défaut, représentés hachurés sur la figure 8A, sont affectés par la fuite de charges.

La figure 8B illustre, selon une vue de dessus, un dispositif de photo-détection 500' qui ne diffère de celui des figures 5 et 8A qu'en ce que les bandes dopées 570 forment des segments disjoints, qui s'étendent le long de lignes droites 571, d'un bord à l'autre de la matrice de pixels. Par disjoints, on entend espacés deux à deux, sans contact physique entre eux. En d'autres termes, les bandes dopées 570 s'étendent selon une grille discontinue, avec un plot de contact électrique 140 dans chaque trou de la grille. Dans l'exemple illustré ici, les pixels de la matrice de pixels sont répartis selon un maillage carré, ou rectangulaire, et chaque plot de contact électrique 140 est encadré par quatre bandes dopées 570 distinctes disposées selon les quatre côtés d'un carré ou d'un rectangle.

L'espacement $d_s$, entre deux bandes dopées 570 voisines dont les axes d'allongement respectifs sont alignés sur une même ligne droite, est inférieur ou égal à deux fois l'étendue latérale de la zone de déplétion dans la couche de contact. On s'assure ainsi d'avoir, dans la couche de contact, des zones de déplétion qui s'étendent continûment d'un bord à l'autre de la matrice de pixels. L'étendue latérale d'une zone de déplétion est son étendue à compter d'une extrémité voisine de la bande dopée associée, mesurée dans un plan parallèle au plan (x0y). De préférence, l'étendue latérale d'une zone de déplétion, dans la couche de contact, est égale à son étendue dans le sens de la profondeur dans cette même couche de contact.

L'invention couvre aussi des variantes du premier mode de réalisation de l'invention, dans lesquelles les bandes métalliques formant des capacités MOS s'étendent selon une grille discontinue. Là encore, il s'agit de limiter un nombre de pixels affectés par une fuite de charges due à un défaut local dans la capacité MOS. Les bandes métalliques disjointes doivent alors être polarisées chacune individuellement, alors qu'un unique point de contact électrique suffit pour polariser les bandes métalliques lorsqu'elles sont agencées selon une grille continue. En complément ou en variante, on limite l'effet d'une fuite de charges en augmentant la tension de polarisation des bandes métalliques, en valeur absolue.

L'invention n'est pas limitée aux exemples décrits ci-dessus, et couvre également de nombreuses variantes, par exemple avec d'autres maillages de répartition des pixels, ou avec un gradient de gap dans la couche d'absorption et/ou dans la couche de contact (qui n'empêche pas le fonctionnement de la couche barrière en tant que barrière unipolaire). On a décrit ici un dispositif de type « nBn », mais l'invention couvre aussi les variantes de type « pBn », « pBp » et « nBp », correspondant à d'autres types de dopage pour la couche de contact et/ou la couche barrière, et avec une couche barrière dopée n ou p. Selon les types de dopage, la barrière unipolaire est formée par une différence de gap qui se reporte plutôt sur la bande de valence ou sur la bande conduction. Dans le deuxième mode de réalisation, le dopage des bandes dopées est adapté pour qu'elles forment toujours une jonction p-n ou n-p avec la couche de contact. De même, l'invention n'est pas limitée aux matériaux semi-conducteurs mentionnés en exemple, pour la couche d'absorption, la couche barrière et la couche de contact, et couvre l'ensemble des matériaux semi-conducteurs propices à la photo-détection infrarouge :

Si, Ge, AsGa, InP, InSb, InAs, GaSb, AlSb, InGaAs, InAs-Sb, super réseaux de type II InAs/GaSb, HgCdTe, etc. En tout état de cause, la couche d'absorption, la couche barrière et la couche de contact sont avantageusement constituées chacune d'un matériau semi-conducteur III-V. L'homme du métier saura également mettre en oeuvre différents dimensionnements de la couche de contact et des éléments de séparation selon l'invention, en utilisant des équations classiques des semi-conducteurs et/ou des capacités MOS. En tout état de cause, la pixellisation selon l'invention est assurée en maîtrisant simplement des valeurs de densité de dopage et d'épaisseur, définies à des étapes d'épitaxie. Cela permet d'assurer la pixellisation avec une très grande homogénéité, sur l'ensemble de la matrice de pixels et d'une matrice de pixels à l'autre. Selon d'autres variantes encore, les capacités MOS pour délimiter les pixels de la matrice de pixels ne sont pas polarisées.

L'invention est particulièrement avantageuse dans le cadre d'un dispositif de photo-détection dans lequel la couche barrière est constituée d'un matériau susceptible de s'oxyder à l'air libre, par exemple un matériau comprenant de l'aluminium, et plus particulièrement un alliage III-V contenant de l'aluminium tel que l'AlAsSb.

L'invention couvre avantageusement des dispositifs de photo-détection sensibles dans l'infrarouge, sur des plages de longueur d'onde comprises entre 0,8 $\mu m$ et 20 $\mu m$, plus préférentiellement entre 2,5 $\mu m$ et 5 $\mu m$. L'invention concerne plus particulièrement des détecteurs infrarouge quantiques fonctionnant entre 150K et 200K.

## Revendications

1. Dispositif de photo-détection (100; 500 ; 500') comportant une matrice de pixels, où chaque pixel (10) comprend un photo-détecteur à barrière, et où ladite matrice de pixels comporte :

   - une couche d'absorption (110), une couche barrière (120) , et une couche de contact (130), agencées superposées avec la couche barrière (120) située entre la couche d'absorption (110) et la couche de contact (130), où la couche barrière (120) est apte à former une barrière de potentiel bloquant la circulation de porteurs majoritaires entre la couche d'absorption (110) et la couche de contact (130) et autorisant la circulation de porteurs minoritaires depuis la couche d'absorption (110) vers la couche de contact (130) ; et
   - au moins un élément de séparation (150, 160; 570), pour délimiter les pixels de ladite matrice de pixels ;

   caractérisé en ce que l'au moins un élément de séparation (150, 160 ; 570) s'étend au-dessus de la couche de contact (130), du côté opposé à la couche barrière, et en ce que l'au moins un élément de séparation (150, 160 ; 570) est apte à former au moins une zone de déplétion qui s'étend dans la couche de contact (130) et qui forme une barrière de potentiel bloquant la circulation de porteurs de charges d'un pixel (10) à l'autre de la matrice de pixels.

2. Dispositif (100 ; 500 ; 500') selon la revendication 1, caractérisé en ce qu'il est configuré pour qu'en fonctionnement, l'au moins une zone de déplétion s'étende sur toute l'épaisseur (h3) de la couche de contact (130).

3. Dispositif (100) selon la revendication 1 ou 2, caractérisé en ce que l'au moins un élément de séparation comprend une pluralité de bandes métalliques (160), agencées le long de lignes de séparation entre les pixels (10), et au moins une couche (150) en matériau électriquement isolant située entre la couche de contact (130) et lesdites bandes métalliques (160), de manière à former au moins une capacité Métal-Oxyde-Semiconducteur (16) qui s'étend le long desdites lignes de séparation entre les pixels.

4. Dispositif (100) selon la revendication 3, caractérisé en ce que les bandes métalliques (160) sont électriquement connectées à une source de tension configurée pour fournir une tension de polarisation (V1) non nulle.

5. Dispositif (100) selon la revendication 4, caractérisé en ce que la source de tension est configurée pour fournir une tension de polarisation (V1) supérieure ou égale à 500 mV en valeur absolue.

6. Dispositif (100) selon l'une quelconque des revendications 3 à 5, caractérisé en ce que chaque pixel (10) de la matrice de pixels comporte en outre un plot de contact électrique (140), situé directement sur la couche de contact (130) du côté opposé à la couche barrière, et en ce que les bandes métalliques (160) sont constituées d'un même matériau que lesdits plots de contact électrique (140).

7. Dispositif (100) selon l'une quelconque des revendications 3 à 6, caractérisé en ce que chaque pixel (10) de la matrice de pixels comporte en outre un plot de contact électrique (140), situé directement sur la couche de contact (130) du côté opposé à la couche barrière, et en ce que l'au moins une couche (150) en matériau électriquement isolant recouvre l'intégralité de la couche de contact (130) excepté aux emplacements desdits plots de contact électrique (140).

8. Dispositif (500; 500') selon la revendication 1 ou 2, caractérisé en ce que l'au moins un élément de séparation comporte des bandes dopées (570) en matériau semi-conducteur, situées chacune directement sur la couche de contact (130) du côté opposé à la couche barrière, et présentant chacune un dopage n ou p de manière à former une jonction p-n ou n-p avec la couche de contact.

9. Dispositif (500 ; 500') selon la revendication 8, **caractérisé en ce que** les bandes dopées (570) ne sont pas connectées à une source de tension pour polariser ces dernières.

10. Dispositif (500; 500') selon la revendication 8 ou 9, **caractérisé en ce que** l'épaisseur des bandes dopées (570) est inférieure ou égale à 15 nm, où l'épaisseur est mesurée selon un axe orthogonal au plan de la matrice de pixels.

11. Dispositif (100 ; 500) selon l'une quelconque des revendications 1 à 10, **caractérisé en ce que** l'au moins un élément de séparation a la forme d'une grille continue.

12. Dispositif (500') selon l'une quelconque des revendications 1 à 10, **caractérisé en ce que** l'au moins un élément de séparation a la forme d'une grille discontinue, constituée d'une pluralité d'éléments de séparation (570) disjoints.

13. Dispositif (500') selon la revendication 12, **caractérisé en ce qu'**une distance ($d_s$), entre deux éléments de séparation (570) répartis le long d'une même ligne droite (571) reliant deux bords opposés de la matrice de pixels, est inférieure ou égale à deux fois une étendue de la zone de déplétion dans la couche de contact (130) et dans le sens de la profondeur.

14. Dispositif (500') selon la revendication 12 ou 13, **caractérisé en ce que** les pixels de la matrice de pixels sont agencés selon un maillage carré ou rectangulaire, et **en ce que** chaque pixel (10) est encadré par quatre éléments de séparation disjoints.

15. Dispositif (100 ; 500; 500') selon l'une quelconque des revendications 1 à 14, **caractérisé en ce que** les photo-détecteurs à barrière sont de type nBn, avec la couche d'absorption (110) dopée n et la couche de contact (130) dopée n.

**Patentansprüche**

1. Fotodetektionsvorrichtung (100; 500; 500'), die eine Pixelmatrix umfasst, wobei jedes Pixel (10) einen Barriere-Fotodetektor umfasst, und wobei die Pixelmatrix Folgendes umfasst:

- eine Absorptionsschicht (110), eine Barriereschicht (120) und eine Kontaktschicht (130), die übereinander liegend angeordnet sind, wobei sich die Barriereschicht (120) zwischen der Absorptionsschicht (110) und der Kontaktschicht (130) befindet, wobei die Barriereschicht (120) dazu in der Lage ist, eine potenzielle Barriere zu bilden, die die Zirkulation von Majoritätsträgern zwischen der Absorptionsschicht (110) und der Kontaktschicht (130) blockiert und die Zirkulation von Minoritätsträgern von der Absorptionsschicht (110) zur Kontaktschicht (130) ermöglicht; und
- mindestens ein Trennelement (150, 160; 570), um die Pixel der Pixelmatrix zu begrenzen;

**dadurch gekennzeichnet, dass** sich das mindestens eine Trennelement (150, 160; 570) oberhalb der Kontaktschicht (130) auf der der Barriereschicht gegenüberliegenden Seite erstreckt und dass das mindestens eine Trennelement (150, 160; 570) dazu in der Lage ist, mindestens eine Verarmungszone zu bilden, die sich in der Kontaktschicht (130) erstreckt und die eine Potentialbarriere bildet, die die Zirkulation von Ladungsträgern eines Pixels (10) zum anderen der Pixelmatrix blockiert.

2. Vorrichtung (100; 500; 500') nach Anspruch 1, **dadurch gekennzeichnet, dass** sie so konfiguriert ist, dass sich die mindestens eine Verarmungszone betriebsmäßig über die gesamte Dicke (h3) der Kontaktschicht (130) erstreckt.

3. Vorrichtung (100) nach Anspruch 1 oder 2, **dadurch gekennzeichnet, dass** das mindestens eine Trennelement eine Vielzahl von Metallstreifen (160), die entlang der Trennlinien zwischen den Pixeln (10) angeordnet sind, und mindestens eine Schicht (150) aus einem elektrisch isolierenden Material umfasst, die zwischen der Kontaktschicht (130) und den Metallstreifen (160) angeordnet ist, um mindestens einen Metalloxid-Halbleiterkondensator (16) zu bilden, der sich entlang der Länge der Trennlinien zwischen den Pixeln erstreckt.

4. Vorrichtung (100) nach Anspruch 3, **dadurch gekennzeichnet, dass** die Metallstreifen (160) elektrisch mit einer Spannungsquelle verbunden sind, die so konfiguriert ist, dass sie eine von Null verschiedene Polarisationsspannung (V1) bereitstellt.

5. Vorrichtung (100) nach Anspruch 4, **dadurch gekennzeichnet, dass** die Spannungsquelle so konfiguriert ist, dass sie eine Polarisationsspannung (V1) mit einem Absolutwert größer gleich 500 mV bereitstellt.

6. Vorrichtung (100) nach einem der Ansprüche 3 bis 5, **dadurch gekennzeichnet, dass** jedes Pixel (10) der Pixelmatrix ferner eine elektrische Kontaktfläche (140) aufweist, die sich direkt auf der Kontaktschicht (130) auf der der Barriereschicht gegenüberliegenden Seite befindet, und dass die Metallstreifen (160) aus dem gleichen Material wie die elektrischen Kontaktflächen (140) bestehen.

7. Vorrichtung (100) nach einem der Ansprüche 3 bis 6, **dadurch gekennzeichnet, dass** jedes Pixel (10) der Pixelmatrix ferner eine elektrische Kontaktfläche (140) aufweist, die sich direkt auf der Kontaktschicht (130) auf der der Barriereschicht gegenüberliegenden Seite befindet, und dass die mindestens eine Schicht (150) aus einem elektrisch isolierenden Material die gesamte Kontaktschicht (130) mit Ausnahme der Stellen der elektrischen Kontaktflächen (140) bedeckt.

8. Vorrichtung (500; 500') nach Anspruch 1 oder 2, **dadurch gekennzeichnet, dass** das mindestens eine Trennelement dotierte Streifen (570) aus einem Halbleitermaterial umfasst, die sich jeweils direkt auf der Kontaktschicht (130) auf der der Barriereschicht gegenüberliegenden Seite befindet, und jeweils eine n- oder p-Dotierung aufweisen, um einen p-n- oder n-p-Übergang mit der Kontaktschicht zu bilden.

9. Vorrichtung (500; 500') nach Anspruch 8, **dadurch gekennzeichnet, dass** die dotierten Streifen (570) nicht mit einer Spannungsquelle verbunden sind, um diese zu polarisieren.

10. Vorrichtung (500; 500') nach Anspruch 8 oder 9, **dadurch gekennzeichnet, dass** die Dicke derdotierten Streifen (570) kleiner gleich 15 nm ist, wobei die Dicke entlang einer Achse orthogonal zur Ebene der Pixelmatrix gemessen wird.

11. Vorrichtung (100; 500) nach einem der Ansprüche 1 bis 10, **dadurch gekennzeichnet, dass** das mindestens eine Trennelement die Form eines durchgehenden Gitters aufweist.

12. Vorrichtung (500') nach einem der Ansprüche 1 bis 10, **dadurch gekennzeichnet, dass** das mindestens eine Trennelement die Form eines durchgehenden Gitters aufweist, das aus einer Vielzahl von losgelösten Trennelementen (570) besteht.

13. Vorrichtung (500') nach Anspruch 12, **dadurch gekennzeichnet, dass** ein Abstand ($d_s$) zwischen zwei Trennelementen (570), die entlang derselben Geraden (571) verteilt sind, die zwei gegenüberliegende Kanten der Pixelmatrix verbindet, kleiner gleich der doppelten Ausdehnung der Verarmungszone in der Kontaktschicht (130) und in der Tiefenrichtung ist.

14. Vorrichtung (500') nach Anspruch 12 oder 13, **dadurch gekennzeichnet, dass** die Pixel der Pixelmatrix in einem quadratischen oder rechteckigen Netz angeordnet sind und dass jedes Pixel (10) von vier losgelösten Trennelementen umgeben ist.

15. Vorrichtung (100; 500; 500') nach einem der Ansprüche 1 bis 14, **dadurch gekennzeichnet, dass** die Barriere-Fotodetektoren vom nBn-Typ sind, wobei die Absorptionsschicht (110) n-dotiert ist und die Kontaktschicht (130) n-dotiert ist.

## Claims

1. Photodetection device (100; 500; 500') comprising a pixel matrix, wherein each pixel (10) comprises a barrier photodetector, and wherein said pixel matrix comprises:

   - an absorption layer (110), a barrier layer (120) and a contact layer (130), arranged to be superposed with the barrier layer (120) located between the absorption layer (110) and the contact layer (130), wherein the barrier layer (120) can form a potential barrier blocking the circulation of majority carriers between the absorption layer (110) and the contact layer (130) and allowing the circulation of minority carriers from the absorption layer (110) to the contact layer (130); and
   - at least one separation element (150, 160; 570), to delimit the pixels of said pixel matrix; **characterised in that** the at least one separation element (150, 160; 570) extends above the contact layer (130) on the side opposite the barrier layer, and **in that** the
   wherein at least one separation element (150, 160; 570) is able to form at least one depletion zone that extends in the contact layer (130) and that forms a potential barrier blocking the circulation of charge carriers from one pixel (10) to another in the pixel matrix.

2. Device (100; 500; 500') according to claim 1, **characterised in that** it is configured such that, during operation, the at least one depletion zone extends across the entire thickness (h3) of the contact layer (130).

3. Device (100) according to claim 1 or 2, **characterised in that** the at least one separation element comprises:

   - a plurality of metallic bands (160), arranged along separation lines between pixels (10), and
   - at least one layer (150) made of an electrically insulating material, located between the contact layer (130) and said metallic bands (160),

so as to form at least one Metal-Oxide-Semiconductor capacitor (16) that extends along said separation lines between the pixels.

4. Device (100) according to claim 3, **characterised in that** the metallic bands (160) are electrically connected to a voltage source configured to supply a non-zero biasing voltage V1.

5. Device (100) according to claim 4, **characterised in that** the voltage source is configured to supply a polarisation voltage(V1) with an absolute value greater than or equal to 500 mV.

6. Device (100) according to any one of claims 3 to 5:

   - each pixel (10) in the pixel matrix also comprises an electrical contact pad (140), located directly on the contact layer (130) on the side opposite the barrier layer, and
   - the metallic bands (160) are composed of the same material as said electrical contact pads (140).

7. Device (100) according to any one of claims 3 to 6, **characterised in that** :

   - each pixel (10) in the pixel matrix also comprises an electrical contact pad (140), located directly on the contact layer (130) on the side opposite the barrier layer, and
   - the at least one layer (150) made of an electrically insulating material covers the entire contact layer (130) except at the locations of said electrical contact pads (140).

8. Device (500; 500') according to claim 1 or 2, **characterised in that** the at least one separation element comprises doped bands (570) made of a semiconducting material, each located directly on the contact layer (130) on the side opposite the barrier layer, and each having an n or p doping so as to form a p-n or n-p junction with the contact layer.

9. Device (500; 500') according to claim 8, **characterised in that** the doped bands (570) are not connected to a voltage source to polarise the doped bands.

10. Device (500; 500') according to claim 8 or 9, **characterised in that** the thickness of the doped bands (570) is less than or equal to 15 nm, wherein the thickness is measured along an axis orthogonal to the plane of the pixel matrix.

11. Device (100; 500) according to any one of claims 1 to 10, **characterised in that** the at least one separation element is in the form of a continuous grid.

12. Device (500') according to any one of claims 1 to 10, the at least one separation element is in the form of a discontinuous grid, composed of a plurality of detached separation elements.

13. Device (500') according to claim 12, **characterised in that** a distance ($d_s$) between two separation elements (570) distributed along the same straight line (571) connecting two opposite edges of the pixel matrix is less than or equal to twice the extent of the depletion zone in the contact layer (130) and in the direction of the depth.

14. Device (100; 500; 500') according to claim 12 or 13, **characterised in that** pixels in the pixel matrix are distributed in a square or rectangular mesh and **in that** each pixel (10) is surrounded by four detached separation elements.

15. Device (100; 500; 500') according to any one of claims 1 to 14, **characterised in that** the barrier photodetectors are of the nBn type, with the n doped absorption layer (110) and the n doped contact layer (130).

FIG.1

FIG.2A

FIG.2B

FIG.2C

FIG.2D

FIG.3

FIG.4

FIG.5

FIG.6A

FIG.6B

FIG.6C

FIG.6D

FIG.7

FIG.8A

FIG.8B

**EP 3 693 997 B1**

**RÉFÉRENCES CITÉES DANS LA DESCRIPTION**

**Documents brevets cités dans la description**

- US 8502271 B

- EP 3089223 A1